## Europäisches Patentamt

## European Patent Office

## Office européen des brevets

(19)

(11) **EP 1 135 860 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.$^7$: **H03M 1/10**
// H03M1:12

(21) Anmeldenummer: **99961021.5**

(22) Anmeldetag: **29.11.1999**

(86) Internationale Anmeldenummer:
**PCT/EP99/09249**

(87) Internationale Veröffentlichungsnummer:
**WO 00/033465 (08.06.2000 Gazette 2000/23)**

(54) **Verfahren zur Überwachung einer SCHALTUNGSANORDNUNG mit A/D-WANDLER FÜR SICHERHEITSKRITISCHE ANWENDUNGEN**

Method for testing a CIRCUIT with A/D CONVERTER FOR APPLICATIONS THAT ARE CRITICAL IN TERMS OF SAFETY

Procédé PERMETTANT DE TESTER UN circuit avec CONVERTISSEUR A/N DESTINE A DES APPLICATIONS CRITIQUES EN TERMES DE SECURITE

(84) Benannte Vertragsstaaten:
**DE FR GB**

(30) Priorität: **03.12.1998 DE 19855743**
**22.03.1999 DE 19912766**

(43) Veröffentlichungstag der Anmeldung:
**26.09.2001 Patentblatt 2001/39**

(73) Patentinhaber: **Continental Teves AG & Co. oHG**
**60488 Frankfurt (DE)**

(72) Erfinder:
• **OEHLER, Peter**
**D-65929 Frankfurt-Höchst (DE)**

• **FEY, Wolfgang**
**D-65527 Niedernhausen (DE)**

(56) Entgegenhaltungen:
**WO-A-97/49188**     **US-A- 5 870 042**

• **W. HENKEL: "Bestimmung der Linearität von A/D-Umsetzern" ELEKTRONIK., Nr. 15, 27. Juli 1984 (1984-07-27), Seiten 85-86, XP002135648 FRANZIS VERLAG GMBH. MUNCHEN., DE ISSN: 0013-5658**

**Beschreibung**

Die Erfindung betrifft ein Verfahren zur Überwachung einer Schaltungsanordnung mit einem A/D-Wandler insbesondere für sicherheitskritische Anwendungen.

Bei Schaltungen für sicherheitskritische Anwendungen und Systeme ist die Zuverlässigkeit und ein fehlerfreier Betrieb von besonderer Bedeutung. Insbesondere ist sicherzustellen, daß im Falle einer Fehlfunktion einer Komponente das Gesamtsystem nicht gefährdet wird. Um dieses Ziel zu erreichen, ist es notwendig, Fehler in der betreffenden Komponente zu erkennen und geeignete Maßnahmen zu ergreifen.

Eine solche, auf fehlerfreien Betrieb zu überwachende Komponente ist zum Beispiel ein A/D (Analog/Digital) -Wandler. Es ist bekannt, zwei identische A/D-Wandler parallel zu betreiben, die Ausgangssignale beider Wandler auf Gleichheit zu überwachen und eine Fehlermeldung zu erzeugen, wenn die Gleichheit - unter Berücksichtigung der üblichen Wandlertoleranzen - nicht mehr gegeben ist. Da ein A/D-Wandler insbesondere bei höheren Ansprüchen an Geschwindigkeit und Genauigkeit jedoch relativ aufwendig in der Realisierung ist, wird diese Lösung aus Kostengründen im allgemeinen als nachteilig angesehen.

Aus der US-A-5 870 042 geht eine Schaltungsanordnung mit A/D-Wandler hervor, welche einen Rampensignalgenerator und eine Testschaltung zur Überprüfung des A/D-Wandlers umfaßt. Das Verfahren bezieht sich ausschließlich auf A/D-Wandler, welche vom "subranging"-Typ sind. Ein vollständiger Rampendurchlauf wird nicht durchgeführt.

Die WO 97 49188 A betrifft ein Verfahren zum Testen eines A/D-Wandlers, bei dem lediglich das LSB des A/D-Wandlers betrachtet wird. Ein vollständiger Durchlauf des Spannungsbereich erfolgt demzufolge nicht.

Der Erfindung liegt die Aufgabe zugrunde, ein Verfahren zur Überwachung einer Schaltungsanordnung mit einem A/D-Wandler anzugeben, bei dem die für sicherheitskritische Anwendungen erforderliche Überwachung der Funktion des A/D-Wandlers mit geringerem Schaltungsaufwand möglich ist.

Gelöst wird diese Aufgabe gemäß dem Verfahren in Anspruch 1. Nach dem Verfahren wird eine Schaltungsanordnung der eingangs genannten Art, die sich auszeichnet durch einen Rampensignalgenerator zur Erzeugung einer dem Eingang des A/D-Wandlers zugeführten Rampenspannung, sowie eine Testschaltung zur Aktivierung eines Testzyklus eingesetzt.

Ein besonderer Vorteil dieser Lösung besteht darin, daß durch die Referenzmessung im ersten Durchlauf und die dadurch mögliche Kompensation verschiedener Toleranzen des Rampensignalgenerators dessen Schaltungsaufwand relativ gering gehalten werden kann.

Die Unteransprüche haben vorteilhafte Weiterbildungen der Erfindung zum Inhalt. Danach kann die Übertragungskenngröße eine Ausgangsspannung oder eine Anzahl von Abtastungen sein.

Weitere Einzelheiten, Merkmale und Vorteile der Erfindung ergeben sich aus der folgenden Beschreibung einer bevorzugten Ausführungsform anhand der Zeichnung. Es zeigt:

Fig. 1 ein Prinzipschaltbild einer erfindungsgemäßen Schaltungsanordnung mit einem A/D-Wandler;
Fig. 2 ein Rampensignal zum Ansteuern eines A/D-Wandlers;
Fig. 3 ein Zustandsübergangsdiagramm zur Verdeutlichung des erfindungsgemäßen Betriebs eines A/D-Wandlers;
Fig. 4 ein Flußdiagramm eines ersten Teils eines ersten, zweiten und dritten erfindungsgemäßen Verfahrens;
Fig. 5 ein Flußdiagramm eines zweiten Teils des ersten erfindungsgemäßen Verfahrens;
Fig. 6 ein Flußdiagramm eines zweiten Teils des zweiten erfindungsgemäßen Verfahrens; und
Fig. 7 ein Blockschaltbild einer erfindungsgemäßen Schaltungsanordnung.

Ein wesentlicher Kern der erfindungsgemäßen Lösung besteht darin, einen A/D-Wandler im laufenden Normalbetrieb ständig im Hinblick auf seine Funktionsfähigkeit zu überwachen. Zu diesem Zweck kommen bis zu vier Kriterien zur Anwendung. Dies sind zum einen die Einhaltung der Toleranzen der statischen Genauigkeit. Hierzu gehören Offsetfehler, Verstärkungsfehler, integrale und differentielle Linearitätsfehler, sowie Quantisierungsfehler und Rauschen. Diese Größen werden zu der sogenannten totalen Umsetzgenauigkeit zusammengefaßt.

Als zweites Kriterium dient eine Prüfung auf Taktausfall. Das dritte Kriterium besteht in dem zeitlichen Verhalten des A/D-Wandlers, und zwar im Hinblick auf die Lage der Abtastfrequenz innerhalb eines zulässigen Toleranzbereiches, sowie im Hinblick auf eine korrekte Ermittlung der Abtastwerte im Normalbetrieb.

Das vierte Kriterium dient einer Überwachung der Referenzspannung des A/D-Wandlers.

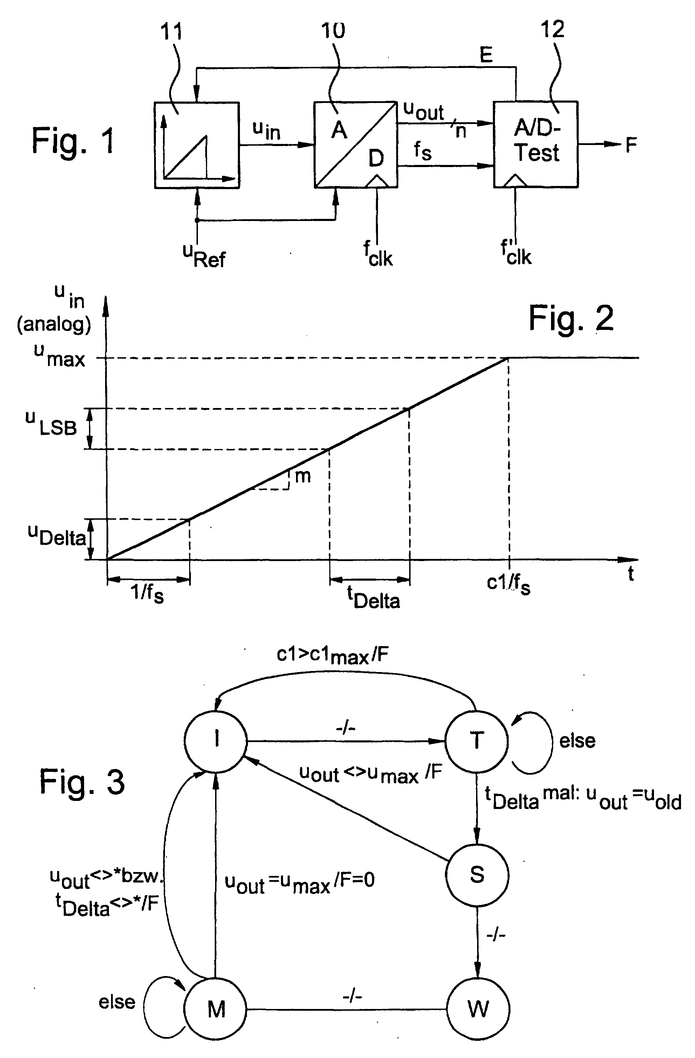

Ein Prinzipschaltbild einer entsprechenden erfindungsgemäßen Schaltungsanordnung ist in Figur 1 gezeigt. Mit dem Eingang eines zu überwachenden A/D-Wandlers 10 ist ein Rampensignalgenerator 11 verbunden. Am Ausgang des A/D-Wandlers 10 liegt eine Testschaltung an. Der A/D-Wandler 10 setzt die an seinem Eingang anliegende analoge Rampenspannung $u_{in}$, die in Figur 2 dargestellt ist, in eine digitale Ausgangsspannung $u_{out}$ um, die mit der Testschaltung 12 ausgewertet wird. Die Testschaltung wird dabei von dem Abtastsignal $f_s$ des A/D-Wandlers getriggert und erzeugt ein Entladesignal E für den betreffenden Kondensator des Rampensignalgenerators.

Die Steigung m der in Figur 2 gezeigten Rampenspannung ergibt sich aus dem Strom I der Referenzstromquelle und der Kapazität C des Kondensators zu $m = I/C$. Aus den Toleranzen der Bauelemente ergibt sich eine minimale Rampensteigung $m_{min} = I_{min}/C_{max}$ und eine maximale Rampensteigerung $m_{max} = I_{max}/C_{min}$. Außerdem gilt $m = (u_{max} * f_s) / c1$, wobei $u_{max}$ die maximale Rampenspannung und cl der Zählerstand beim Erreichen von $u_{max}$ ist. Weiterhin gilt $m = (u_{Delta} * f_s) / 1 = u_{LSB} / t_{Delta}$, wobei $u_{Delta}$ die Spannungsänderung pro Abtastung und $t_{Delta}$ die Zeit ist, die zur Änderung der Spannung um 1 LSB benötigt wird. Diese Zusammenhänge sind auch in Figur 2 eingetragen, wobei die Darstellung allerdings nicht maßstabsgetreu ist.

Das Grundprinzip bei der erfindungsgemäßen Lösung besteht darin, die Rampenspannung $u_{in}$ am Eingang des A/D-Wandlers 10 zwei Mal durchlaufen zu lassen und verschiedene Messungen bezüglich der Ausgangssignale $u_{out}$ vorzunehmen. Mit dem ersten Durchlauf wird die Zeitdauer gemessen, die der Rampensignalgenerator 11 benötigt, um die Rampenspannung von einer negativen Referenzspannung -$U_{Ref}$ bzw. dem Wert Null (Masse) bis zum Rampenanschlag, das heißt maximal bis zur positiven Referenzspannung +$U_{Ref}$ bzw. $u_{max}$ zu erhöhen. Diese Zeitdauer wird als Vielfaches der Abtastzeit des A/D-Wandlers erfaßt.

Diese Messung dient zur Eliminierung von verschiedenen Toleranzen des Rampensignalgenerators 11 aus den Ergebnissen des zweiten Durchlaufs.

Im einzelnen sind dies Toleranzen der Referenzspannung $U_{Ref}$ des A/D-Wandlers, des Endwertes $u_{max}$ der Rampe (sofern $u_{max} <> U_{Ref}$ ist), sowie eine Veränderung der durch die Toleranzen des Stroms I der Referenzstromquelle sowie der Kapazität C des Kondensators bewirkten Rampensteigung. Durch die Kompensation dieser Toleranzen kann im übrigen der Schaltungsaufwand für den Rampengenerator in akzeptablen Grenzen gehalten werden.

In einem zweiten Durchlauf wird nun geprüft, ob verschiedene Übertragungskenngrößen des A/D-Wandlers im spezifizierten Toleranzbereich liegen. Für diesen Durchlauf werden drei verschiedene Verfahren beschrieben, von denen in Abhängigkeit von der gewünschten Genauigkeit und Zuverlässigkeit eines oder mehrere durchgeführt werden können.

Diese beiden Durchläufe werden durch das in Figur 3 dargestellte Grundgerüst eines Zustandsübergangsdiagramms der Testschaltung 12 verdeutlicht.

Der erste Durchlauf beginnt mit einer Initialisierung (I), mit der der Kondensator des Rampensignalgenerators mit dem Entladesignal E (Figur 1) entladen und ein erster Zähler zurückgesetzt wird. Während anschließend die Rampenspannung hochfährt, zählt ein erster Zähler die Abtastsignale. Falls nach einer bestimmten Zeit (Erreichen eines maximalen Zählerstandes $c1_{max}$) kein Rampenanschlag festgestellt wird, wird ein Fehlersignal F erzeugt. Wenn ein Rampenanschlag erkannt wird, geht die Testschaltung in den Setup-Zustand (S) über. Zum Abschluß dieses ersten Durchlaufs wird nun noch überprüft, ob die erreichte maximale Rampenspannung $u_{max}$ innerhalb eines spezifizierten Toleranzbereiches ("full scale error") liegt. Wenn dies nicht der Fall ist, wird das Fehlersignal F erzeugt.

Wenn keines der genannten Fehlersignale f erzeugt wurde, werden je nach dem gewählten Verfahren $u_{Delta}$ bzw. $t_{Delta}$ berechnet sowie der Kondensator des Rampensignalgenerators erneut entladen und - sofern der A/D-Wandler eine Berechnungszeit (Latenzzeit) von einer Abtastzeit besitzt - ein Wartezustand (W) eingelegt.

In dem nun folgenden zweiten Durchlauf (M) werden wahlweise eines oder mehrere der oben genannten drei Verfahren durchgeführt, wobei mit dem ersten und zweiten Verfahren zu bestimmten Zeitpunkten Spannungen geprüft werden, während mit dem dritten Verfahren zu bestimmten Spannungsänderungen Zeiten erfaßt werden. Wenn diese Spannungen bzw. Zeiten außerhalb der Toleranzbereiche liegen, wird das Fehlersignal erzeugt. Andernfalls wird bei Erfassung des Rampenanschlages die Messung als fehlerfrei beendet und die nächste Messung initialisiert (I).

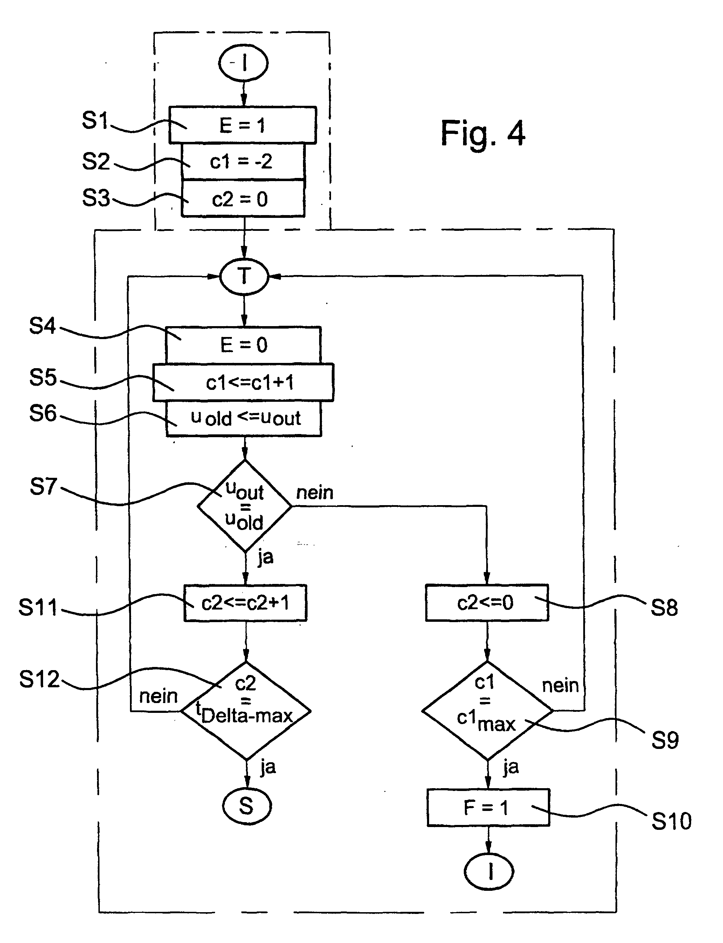

Figur 4 zeigt das Flußdiagramm des Ablaufes der Zustände I (Initialisierung) und T (Zeitmessung), die mit der Testschaltung durchgeführt werden und die für alle drei Verfahren gleich sind.

Die Initialisierung I beginnt mit einem Schritt S1 mit der Erzeugung des Entladesignals E für den Kondensator C des Rampensignalgenerators. Anschließend wird mit einem Schritt S2 der Stand c1 eines erster Zähler zurückgesetzt, und zwar auf einen Wert von -2, wodurch Verzögerungen durch den Algorithmus und die Berechnungszeit des A/D-Wandlers (Latentzzeit) kompensiert werden. Außerdem wird mit einem Schritt S3 der Stand c2 eines zweiten Zählers auf Null gesetzt.

Die anschließende Zeitmessung (T) verläuft in zwei Schleifen und beginnt mit einem. Nullsetzen des Entladesignals E mit einem Schritt S4. Außerdem wird gemäß Schritt S5 der Stand c1 des ersten Zählers, mit dem die Anzahl von Abtastungen bis zum Erreichen des Rampenanschlages gezählt wird, um den Wert 1 erhöht und gemäß Schritt S6 die Ausgangsspannung $u_{out}$ des A/D-Wandlers als Wert $u_{old}$ gespeichert. Im Anschluß an Schritt S6 wird gewartet, bis ein neues Abtastsignal erfolgt, so daß ein neuer gewandelter Wert in $U_{out}$ vorliegt (vergl. Seite 5, unten). Anschließend wird mit einem Schritt S7 abgefragt, ob der neue Wert $u_{out}$ der Ausgangsspannung gleich dem alten Wert $u_{old}$ ist. Wenn diese Abfrage mit "nein" zu beantworten ist, wird gemäß Schritt S8 der Stand c2 des zweiten Zählers auf Null gesetzt und gemäß Schritt S9 abgefragt, ob der Stand c1 des ersten Zählers seinen Maximalwert $c1_{max}$ erreicht hat. Wenn dies nicht der Fall ist, wird dieser Ablauf beginnend mit dem Schritt S4 wiederholt, da sich einerseits die Ausgangsspannung $u_{out}$ mit jeder Abtastung noch ändert und andererseits die zum Erreichen des Rampenanschlages erforderliche Anzahl von Abtastungen $c1_{max}$ noch nicht erreicht ist.

Wenn hingegen die Abfrage gemäß Schritt S9 mit "ja" beantwortet wird, das heißt wenn die auch für den ungünstigsten Fall erforderliche, maximale Anzahl $c1_{max}$ von Abtastungen erreicht ist, bei der der Rampenanschlag bei fehlerfreiem A/D-Wandler garantiert erreicht sein müßte, wird gemäß Schritt S10 eine Fehlermeldung aufgrund eines Nichterreichens des Rampenanschlags erzeugt, und der Ablauf wird, beginnend mit der Initialisierung (I), wiederholt.

Sobald sich die Ausgangsspannung $u_{out}$ des A/D-Wandlers gegenüber der vorherigen Abtastung nicht mehr ändert und somit die Abfrage in Schritt S7 mit "ja" zu beantworten ist, wird mit Schritt S11 der Stand c2 des zweiten Zählers um den Wert 1 erhöht und in Schritt S12 abgefragt, ob dieser neue Zählerstand gleich dem wert von $t_{Delta-max}$, das heißt der Anzahl von Abtastungen ist, bei der im ungünstigsten Fall die Ausgangsspannung $u_{out}$ während des Anstiegs der Rampenspannung garantiert um 1 LSB ansteigt. Wenn diese Abfrage mit "nein" beantwortet wird, wird die Zeitmessung T wiederholt und der Ablauf mit Schritt S4 fortgesetzt. Wenn hingegen die Abfrage mit "ja" beantwortet wird, das heißt der Rampenanschlag wurde erreicht, so geht der Testautomat in den Zustand S ("setup") über.

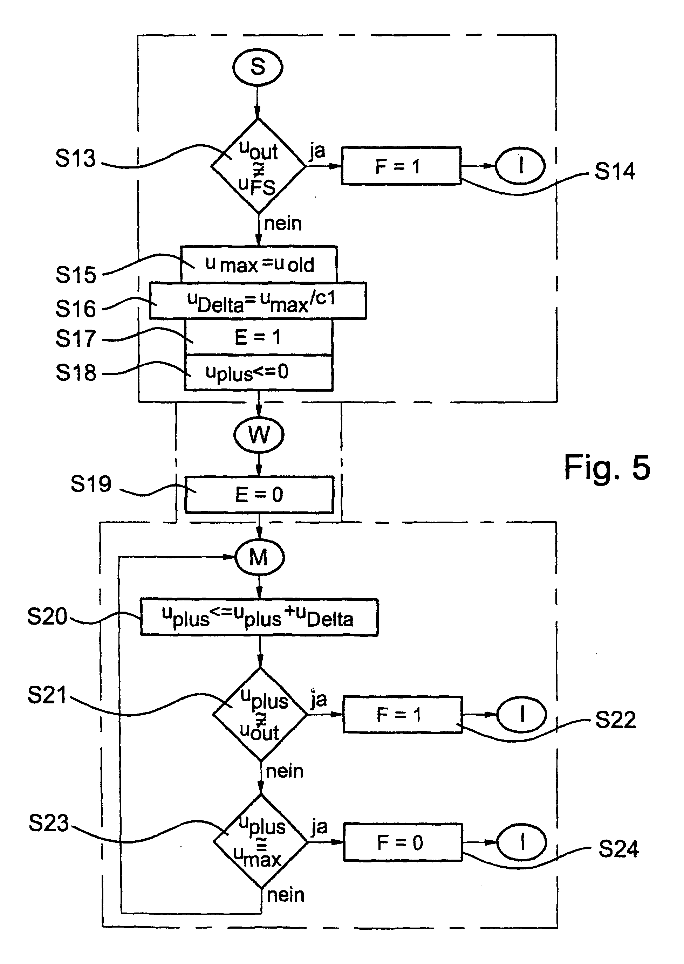

Figur 5 zeigt nun für das erste Verfahren den zweiten Teil (Zustände S, W und M gemäß Figur 3) des weiteren Ablaufs. Der Setup-Zustand S beginnt mit der Abfrage in Schritt S13, ob die gemessene Rampenanschlagspannung $u_{out}$ außerhalb des Toleranzbereiches $u_{FS}$ liegt, wobei $u_{FS}$ der Ausgangswert des A/D-wandlers am Bereichsende ("full scale") ist. Wenn dies der Fall ist, wird mit Schritt S14 ein Fehlersignal F auf den wert 1 gesetzt und der Ablauf mit der Initialisierung I gemäß Figur 4 wiederholt.

Wenn die Abfrage in Schritt S13 mit "nein" beantwortet wird, wird mit Schritt S15 der Wert der maximalen Ausgangsspannung $u_{max}$ auf den letzten Wert $u_{old}$ dieser Spannung gesetzt und in Schritt 16 die mittlere Spannungsänderung $u_{Delta}$ pro Abtastung berechnet ($u_{Delta} = u_{max} / c1$). Anschließend wird mit Schritt S17 der Kondensator des Rampensignalgenerators durch Erzeugung des Entladesignals E = 1 entladen und mit Schritt S18 eine Vergleichsspannung $u_{plus}$, die als berechnete Spannung mit der zu messenden Spannung zu vergleichen ist, auf Null gesetzt.

Der Testautomat nimmt dann den Wartezustand W ein und setzt das Entladesignal E mit Schritt S19 für den Kondensator des Rampensignalgenerators auf Null.

Anschließend werden in dem Meßzustand M die eigentlichen Spannungsmessungen vorgenommen. Zu diesem Zweck wird mit Schritt S20 zunächst die Vergleichsspannung $u_{plus}$ um den Wert $u_{Delta}$ inkrementiert. In Schritt S21 wird dann abgefragt, ob die Ausgangsspannung $u_{out}$ außerhalb des Toleranzbereiches der Vergleichsspannung $u_{plus}$ liegt. Wenn dies der Fall ist, wird mit Schritt S22 ein Fehlersignal F auf den Wert 1 gesetzt und der Ablauf mit der Initialisierung I gemäß Figur 4 wiederholt.

Wenn die Abfrage im Schritt S21 mit "nein" beantwortet wird, wird in Schritt S23 abgefragt, ob die Vergleichsspannung $u_{plus}$ innerhalb des Toleranzbereiches der maximalen Ausgangsspannung $u_{max}$ liegt. Wenn diese Abfrage mit "ja" beantwortet wird, wird gemäß Schritt S24 das Fehlersignal F auf den Wert 0 gesetzt. In diesem Fall ist der Rampenanschlag erreicht, und die Messung wird als fehlerfrei abgeschlossen, da gemäß Schritt S21 die gemessene Ausgangsspannung $u_{out}$ nicht außerhalb des Toleranzbereiches der berechneten Vergleichsspannung $u_{plus}$ liegt. Der gesamte Ablauf kann dann mit der Initialisierung I gemäß Figur 4 wiederholt werden.

Wenn die Abfrage in Schritt S23 mit "nein" beantwortet wird, ist der Rahmenanschlag noch nicht erreicht, und die Spannungsmessung wird durch Rückkehr des Ablaufes zum Beginn des Zustands M wiederholt.

Bei den beiden Toleranzbereichen müssen alle Ungenauigkeiten des A/D-Wandlers geeignet berücksichtigt werden.

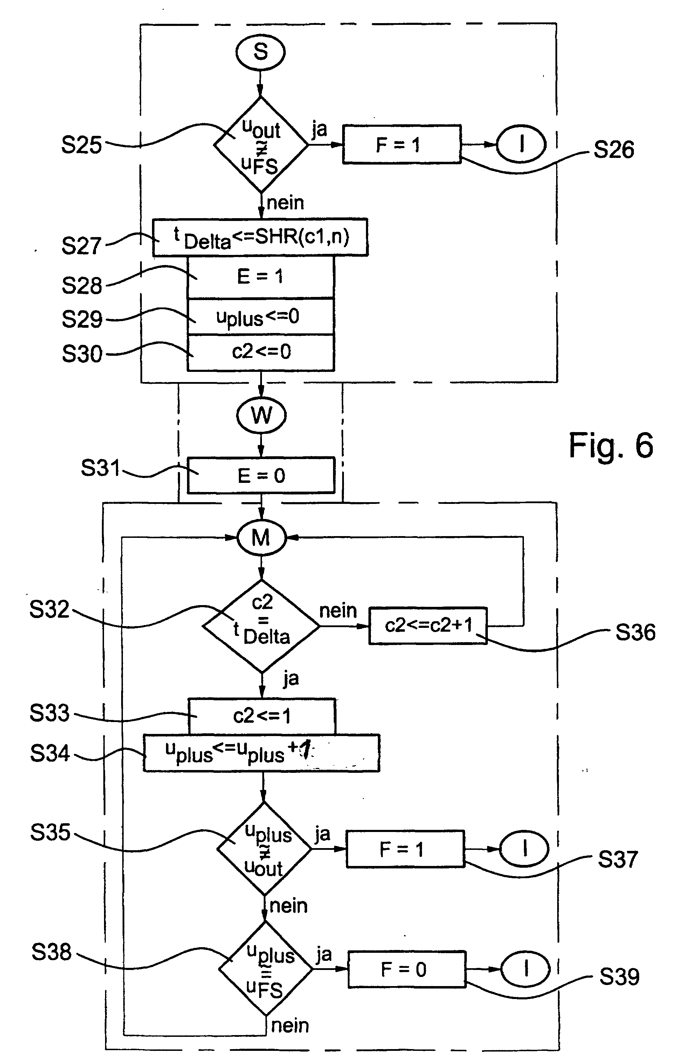

Figur 6 zeigt für das oben genannte zweite Verfahren den zweiten Teil des Ablaufs (Zustände S, W und M). Der wesentliche Unterschied besteht darin, daß im Gegensatz zu dem ersten Verfahren in dem Setup-Zustand S anstelle von $u_{Delta}$ nun $t_{Delta}$ (=1/$u_{Delta}$), das heißt die Zeit, die zur Änderung der Spannung um 1 LSB benötigt wird, berechnet wird.

Diese Berechnung erfolgt durch eine Division oder eine Schiebe-Operation um n Bit nach rechts, sofern als maximale Rampenspannung $u_{max}$ die Referenzspannung $U_{Ref}$ des A/D-Wandlers verwendet wird (in diesem Fall kann auf die Messung von $u_{max}$ verzichtet werden, da diese bis auf den Toleranzbereich [full scale error] bereits bekannt ist).

Während der Messung (zustand M) wird dann alle $t_{Delta}$ geprüft, ob die am A/D-Wandler gemessene Ausgangsspannung $u_{out}$ im zulässigen Toleranzbereich liegt, wobei diese mit einem Sollwert $u_{plus}$ verglichen wird, der alle $t_{Delta}$ um 1 LSB (bzw. Vielfache davon) inkrementiert wird. Alternativ kann dieser Vergleich auch bei jeder Abtastung erfolgen.

Im einzelnen beginnt der Ablauf im Zustand S mit einer Abfrage in Schritt S25, ob die Ausgangsspannung des A/D-Wandlers außerhalb des Toleranzbereiches $u_{FS}$ liegt. Wenn dies der Fall ist, wird mit Schritt S26 das Fehlersignal F auf den Wert 1 gesetzt und der Ablauf durch Rückkehr zur Initialisierung I fortgesetzt. Wenn die Abfrage mit "nein" beantwortet wird, wird mit Schritt S27 der Wert $t_{Delta}$ wie oben angegeben berechnet. Anschließend wird mit Schritt S28 das Entladesignal E für den Kondensator des Rampensignalgenerators auf den Wert 1 gesetzt, in Schritt S29 der Wert der durch Berechnung ermittelten Vergleichsspannung $u_{plus}$ auf den Wert 0, sowie in Schritt S30 der Stand c2 des zweiten Zählers ebenfalls auf den Wert 0 gesetzt.

Während des anschließenden Wartezustands W wird mit Schritt S31 das Entladesignal E für den Kondensator des Rampensignalgenerators auf den Wert 0 gesetzt.

In dem Meßzustand M wird nun die eigentliche Spannungsmessung durchgeführt. Zu diesem Zweck wird zunächst in Schritt S32 abgefragt, ob der Stand c2 des zweiten Zählers der Zeitdauer $t_{Delta}$ entspricht. Wenn dies nicht der Fall ist, wird mit der durch Schritt S36 gebildeten Schleife der Stand c2 solange um 1 inkrementiert, bis die Abfrage in Schritt S32 mit "ja" beantwortet wird. In diesem Fall wird dann der Zählerstand mit Schritt S33 auf den Wert 1 gesetzt und mit Schritt S34 die Vergleichsspannung $u_{plus}$ um den Wert 1 inkrementiert.

Anschließend folgt mit Schritt S35 eine Abfrage, ob die Ausgangsspannung $u_{out}$ außerhalb des Toleranzbereiches der Vergleichsspannung $u_{plus}$ liegt. Wenn dies der Fall ist, wird mit Schritt S37 das Fehlersignal F auf den Wert 1 gesetzt und der Ablauf durch Rückkehr zur Initialisierung I (Figur 4) wiederholt.

Wenn die Ausgangsspannung $u_{out}$ nicht außerhalb des Toleranzbereiches der Vergleichsspannung $u_{plus}$ liegt, wird mit Schritt S38 abgefragt, ob die Vergleichsspannung $u_{plus}$ innerhalb des Toleranzbereiches der Rampenanschlagsspannung $u_{FS}$ liegt. Wenn diese Abfrage mit "ja" beantwortet wird, wird mit Schritt S39 das Fehlersignal F auf den Wert 0 gesetzt und der Ablauf durch Rückkehr zur Initialisierung I fortgesetzt. Im anderen Fall erfolgt ein Rücksprung zum Anfang des Meßzustands M.

Bei dem ersten und zweiten Verfahren findet durch das Aufsummieren von $u_{Delta}$ bzw. das Zählen von $t_{Delta}$ eine Fehlerfortpflanzung statt. Aus diesem Grund muß die Berechnung von $U_{Delta}$ bzw. $t_{Delta}$ durch eine Division mit hoher Genauigkeit, das heißt großer Wortbreite erfolgen. Dies gilt auch für die Weiterverarbeitung.

Ein vorteil des zweiten Verfahrens besteht darin, daß im Vergleich zu dem ersten Verfahren auf einen Dividierer verzichtet werden kann. Ferner kann der Addierer auf eine geringere Wortbreite ausgelegt sein.

Im Gegensatz zu dem beschriebenen ersten und zweiten Verfahren, bei denen zu bestimmten Zeitpunkten Spannungen gemessen werden, werden bei dem dritten Verfahren zu bestimmten Spannungsänderungen Zeiten erfaßt und geprüft, ob diese Zeiten innerhalb der Toleranzbereiche liegen. Zu diesem Zweck wird mit Hilfe des gemessenen Standes cl des ersten Zählers sowie der maximalen Ausgangsspannung $u_{max}$ (bei $u_{max} <> U_{Ref}$) in dem Setup-Zustand S die minimale und die maximale Anzahl von Abtastungen berechnet, die zwischen zwei Spannungsänderungen am Ausgang des A/D-Wandlers unter Berücksichtigung aller Wandler-Ungenauigkeiten gerade noch im tolerierbaren Bereich liegt.

Im Meßzustand M wird dabei nach jeder Spannungsänderung der Zähler zurückgesetzt und so lange inkrementiert, bis am Ausgang des A/D-Wandlers die nächste Spannungsänderung auftritt. Anschließend wird geprüft, ob der Zählerstand in einem Bereich zwischen minimaler und maximaler Anzahl von Abtastungen steht, der für diese Spannungsänderung tolerierbar ist, und ob die differentielle Spannungsänderung im zugelassenen Bereich liegt. Bei diesem dritten Verfahren findet wegen des Rücksetzens des Zählers keine Fehlerfortpflanzung statt, so daß mit geringerer Wortbreite gearbeitet werden kann.

Andererseits ist bei diesem Verfahren zu berücksichtigen, daß die Zeit zwischen zwei Spannungsänderungen als Vielfaches der Abtastzeit gemessen wird. Dies entspricht definitionsgemäß nur einer Messung der differentiellen Nichtlinearität (DNL) in Gestalt einer relativen Messung zwischen zwei Abtastwerten. Absolute Abweichungen von der idealen Übertragungskennlinie, die durch die integrale Nichtlinearität INL ausgedrückt werden, werden dabei nicht erfaßt.

Die Aufsummierung der DNL von "...00" bis zum Rampenanschlag bei "...FF" ergibt gerade die INL. Entsprechend muß nach jedem Spannungssprung am Ausgang des A/D-Wandlers die Summe

$$t_{sum} = t_{sum} + c2 - t_{Delta} (u_{out} - u_{old})$$

gebildet werden. $t_{sum}$ darf sich bei einer INL von +/- 1 LSB (z.B.) nur im Bereich von +/- $t_{Delta}$ bewegen. Dabei ist c2 die gemessene Zeit zwischen dem letzten und dem aktuellen Spannungssprung als Ganzzahliges einer Abtastung. Idealerweise erfolgt ein Sprung um +1 Bit alle $t_{Delta}$. Bedingt durch Rauschen können aber auch Sprünge um -1, +2 oder +3 Bit etc. erfolgen. Dies wird durch die Differenzbildung ($u_{out} - u_{old}$) erfaßt. Wegen der Fehlerfortpflanzung muß bei dieser Aufsummierung $t_{Delta}$ mit einer höheren Auflösung (als bei dem zweiten Verfahren) ausgelegt werden.

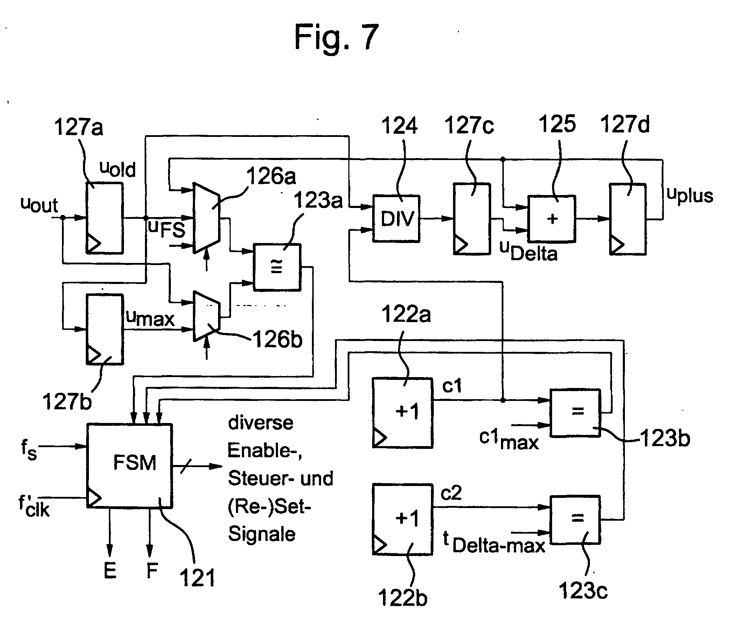

Figur 7 zeigt ein mögliches Blockschaltbild eines Testautomaten 12 zur Durchführung des ersten Verfahrens. Die Schaltung ist digitalisiert und umfaßt im wesentlichen ein Steuerwerk 121, einen ersten und einen zweiten Zähler 122a, 122b, einen ersten, einen zweiten und einen dritten Komparator 123a, 123b, 123c, einen Dividierer 124, einen Addierer 125, einen ersten und einen zweiten Multiplexer 126a, 126b, sowie ein erstes bis viertes Register 127a, 127b, 127c, 127d.

Das Steuerwerk 121, an dem die Abtastfrequenz $f_s$ sowie eine Taktfrequenz $f'_{clk}$ anliegt, erzeugt das Entladesignal E für den Kondensator des Rampensignalgenerators, das Fehlersignal F sowie verschiedene weitere Steuer-, Rücksetz- und Freigabesignale. An dem ersten Register 127a sowie einem ersten Eingang des zweiten Multiplexer 126b liegt die Ausgangsspannung $u_{out}$ des A/D-Wandlers an.

Der Ausgang des ersten Registers 127a ist als Spannungswert $u_{old}$ mit einem ersten Eingang des ersten Multiplexers 126a, dem Eingang des zweiten Registers 127b, sowie einem ersten Eingang des Dividierers 124 verbunden. Der Ausgang des zweiten Registers 127b liegt an einem zweiten Eingang des zweiten Multiplexers 126b an. Die Ausgänge des ersten und zweiten Multiplexers 126a, 126b sind mit jeweils einem Eingang des ersten Vergleichers 123a verbunden, mit dem die Eingangssignale auf Gleichheit unter Berücksichtigung der Toleranzbereiche verglichen werden. Der Ausgang des ersten Vergleichers 123a ist mit dem Steuerwerk 121 verbunden.

Der Ausgang des ersten Zählers 122a ist als Zählerstand cl mit einem zweiten Eingang des Dividierers 124 sowie einem ersten Eingang des zweiten Vergleiches 123b verbunden. Der Ausgang des zweiten Zählers 122b ist als Zählstand c2 mit einem ersten Eingang- des dritten Vergleichers 123c verbunden. An einem zweiten Eingang des zweiten Vergleiches 123b liegt der maximale Zählwert $c1_{max}$ an, während einem zweiten Eingang des dritten Vergleiches 123c der Wert $t_{delta-max}$ zugeführt wird. Die Ausgänge des zweiten und dritten Vergleichers sind mit der Steuereinheit 121 verbunden.

Der Ausgang des Dividierers 124 liegt an dem Eingang des dritten Registers 127c an, dessen Ausgang als Spannungswert $u_{Delta}$ mit einem ersten Eingang des Addierers 125 verbunden ist. Der Ausgang des Addierers 125 ist an den Eingang des vierten Registers 127d geführt, dessen Ausgang als Spannungswert $u_{plus}$ mit einem zweiten Eingang des Addierers 125 sowie einem zweiten Eingang des ersten Multiplexers 126a verbunden ist. An einem dritten Eingang des ersten Multiplexers 126a liegt schließlich der Spannungswert $u_{FS}$ an.

Da bei allen drei Verfahren die Übertragungskenngrößen des A/D-Wandlers nur relativ zur Spannung am Rampenanschlag gemessen werden, müssen sie um die Messung zweier Absolutwerte ergänzt werden, wobei einer davon die Offsetspannung ist.

Der Testautomat kann zur Reduzierung des gesamten Schaltungsaufwandes auch durch ein Rechnerprogramm realisiert werden.

Bezugszeichenliste

10 - A/D-Wandler
11 - Rampensignalgenerator
12 - Testschaltung
121 - Steuerwerk
122a, 122b - erster bzw. zweiter Zähler
123a, 123b, 123c - erster, zweiter bzw. dritter Komparator
124 - Dividierer
125 - Addierer
126a, 126b - erster bzw. zweiter Multiplexer
127a, 127b, 127c, 127d - erstes bis viertes Register

**Patentansprüche**

1. Verfahren zur Überwachung einer Schaltungsanordnung mit A/D-Wandler für sicherheitskritische Anwendungen mit einem Rampensignalgenerator (11) zur Erzeugung einer dem Eingang des A/D-Wandlers (10) zugeführten Rampenspannung, sowie einer Testschaltung (12) zur Aktivierung eines Testzyklus', der einen ersten Durchlauf der Rampe umfaßt, mit dem eine Referenzmessung des Rampensignalgenerators zur Kompensation von Bauelement-Toleranzen durchgeführt wird, sowie einen zweiten Durchlauf der Rampe beinhaltet, bei dem ein Fehlersignal (F) ausgegeben wird, wenn der für eine Übertragungskenngröße des A/D-Wandlers (10) berechnete Wert außerhalb eines vorgegebenen Toleranzbereiches des gemessenen Wertes der Übertragungskenngröße liegt, **dadurch gekennzeichnet, daß**
die Rampe in jedem Rampendurchlauf vollständig durchlaufen wird und mit dem ersten Durchlauf der Rampe die Zeit gemessen wird, die für einen Rampendurchlauf erforderlich ist, wobei diese Zeit als eine Anzahl (c1) von Abtastungen bis zum Erreichen der maximalen Rampenspannung ($u_{max}$) ermittelt wird.

2. Verfahren nach Anspruch 1, **dadurch gekennzeichnet, daß** mit dem ersten Durchlauf der Rampe Toleranzen einer Referenzspannung ($U_{Ref}$) des A/D-Wandlers und der maximalen Rampenspannung ($u_{max}$) sowie der Steigung (m) der Rampenspannung des Rampensignalgenerators kompensiert werden.

3. Verfahren nach Anspruch 1 oder 2,
**dadurch gekennzeichnet, daß** die Übertragungskenngröße die für eine oder eine Mehrzahl (n) von Abtastungen berechnete Ausgangsspannung ($u_{plus}$ + n $u_{Delta}$) ist und das Fehlersignal (F) erzeugt wird, wenn diese außerhalb eines vorgegebenen Toleranzbereiches der bei diesen Abtastungen gemessenen Ausgangsspannung ($u_{out}$) liegt.

4. Verfahren nach Anspruch 1 oder 2,
**dadurch gekennzeichnet, daß** mit der Testschaltung die zur Änderung der Ausgangsspannung um 1 LSB erforderliche Zeitdauer ($t_{Delta}$) berechnet und die Übertragungskenngröße die für eine oder eine Mehrzahl (n) von Zeitdauern ($t_{Delta}$) berechnete Ausgangsspannung ($u_{plus}$) ist und das Fehlersignal (F) erzeugt wird, wenn diese außerhalb eines vorgegebenen Toleranzbereiches der zu den betreffenden Zeitpunkten (n $t_{Delta}$) gemessenen Ausgangsspannung ($u_{out}$) liegt.

5. Verfahren nach Anspruch 1 oder 2,
**dadurch gekennzeichnet, daß** die Übertragungskenngröße die für eine Änderung der Ausgangs-spannung ($u_{out}$) um ein oder eine Mehrzahl von LSBs erforderliche Anzahl von Abtastungen ist und ein Fehlersignal (F) erzeugt wird, wenn diese Anzahl außerhalb eines vorgegebenen Toleranzbereiches der gezählten Anzahl von Abtastungen liegt.

## Revendications

1. Procédé de surveillance d'un circuit avec convertisseur A/N pour des applications de sécurité critique, avec un générateur de signal de rampe (11) pour produire une tension de rampe apportée à l'entrée du convertisseur A/N (10), et avec un montage de test (12) pour activer un cycle de test, qui comprend un premier passage de la rampe avec lequel on effectue une mesure de référence du générateur de signal de rampe afin de compenser des tolérances de composant, et qui comporte un deuxième passage de la rampe au cours duquel est délivré un signal d'erreur (F) si la valeur calculée pour un paramètre de transmission du convertisseur A/N (10) se trouve en dehors d'une plage prescrite de tolérance de la valeur mesurée du paramètre de transmission, **caractérisé en ce que** la rampe est totalement parcourue à chaque passage, et on mesure lors du premier passage de la rampe le temps qui est nécessaire pour un passage de rampe, ce temps étant déterminé sous la forme d'un nombre ($c1$) de balayages jusqu'à l'atteinte de la tension de rampe maximale ($u_{max}$).

2. Procédé selon la revendication 1, **caractérisé en ce que**, lors du premier passage de la rampe, on compense les tolérances d'une tension de référence ($U_{Ref}$) du convertisseur A/N et de la tension de rampe maximale ($u_{max}$), ainsi que de la pente (m) de la tension de rampe du générateur de signal de rampe.

3. Procédé selon la revendication 1 ou 2, **caractérisé en ce que** le paramètre de transmission est la ten-sion de sortie ($U_{plus} + n\ u_{Delta}$) calculée pour un ou plusieurs (n) balayages, et le signal d'erreur (F) est produit si cette tension de sortie se situe en dehors d'une plage prescrite de tolérance de la tension de sortie ($u_{out}$) mesurée lors de ces balayages.

4. Procédé selon la revendication 1 ou 2, **caractérisé en ce que**, avec le montage de test, on calcule la durée nécessaire ($t_{Delta}$) pour une modification de la tension de sortie de 1 LSB et le paramètre de transmission est la tension de sortie ($u_{plus}$) calculée pour une ou plusieurs (n) durées ($t_{Delta}$), et le signal d'erreur (F) est produit si cette tension de sortie se situe en dehors d'une plage prescrite de tolérance de la tension de sortie ($u_{out}$) mesurée aux instants correspondants ($n\ t_{Delta}$).

5. Procédé selon la revendication 1 ou 2, **caractérisé en ce que** le paramètre de transmission est le nombre de balayages qui est nécessaire pour une modification de la tension de sortie ($u_{out}$) d'un ou plu-sieurs LSB, et un signal d'erreur (F) est produit si ce nombre se situe en dehors d'une plage prescrite de tolérance du nombre compté de balayages.

## Claims

1. Method of monitoring a circuit configuration with an A/D converter for applications that are critical in terms of safety, including a ramp signal generator (11) for generating a ramp voltage that is delivered to the input of the A/D converter (10), and a test circuit (12) for activating a test cycle which comprises a first run of the ramp, by which a reference measurement of the ramp signal generator is carried out for compensating component tolerances, and comprises a second run of the ramp where an error signal (F) is output when the value that is calculated for a transmission characteristic quantity of the A/D converter (10) lies outside a predetermined tolerance range of the measured value of the transmission characteristic quantity, **characterized in that** the ramp is passed through totally in each ramp run and, with the first run of the ramp, the period of time is measured which is necessary for a ramp run, and the said time is determined as a number ($c1$) of sampling operations until the maximum ramp voltage ($u_{max}$) is reached.

2. Method as claimed in claim 1, **characterized in that** tolerances of a reference voltage ($U_{Ref}$) of the AID converter and of the max-imum ramp voltage ($u_{max}$) as well as of the gradient (m) of the ramp voltage of the ramp signal generator are compensated with the first run of the ramp.

3. Method as claimed in claim 1 or 2, **characterized in that** the transmission characteristic quantity is the output voltage ($u_{plus} + n\ u_{Delta}$) calculated for one or a plurality (n) of sampling operations, and the error signal (F) is produced when the said output voltage lies outside a predetermined tolerance range of the output voltage ($u_{out}$) meas-ured with these sampling operations.

4. Method as claimed in claim 1 or 2, **characterized in that** with the test circuit, the period of time ($t_{Delta}$) which is necessary for changing the output voltage by 1 LSB is calculated, and the transmission characteristic quantity is the output voltage ($u_{plus}$) calculated for one or a plurality (n) of periods of time ($t_{Delta}$), and the error signal (F) is produced when the said output voltage lies outside a predetermined tolerance range of the output voltage ($u_{out}$) measured at the respective points of time ($n\ t_{Delta}$).

5. Method as claimed in claim 1 or 2, **characterized in that** the transmission characteristic quantity is the number of sampling operations which are necessary for a change of the output voltage ($u_{out}$) by one or a plurality of LSBs, and an error signal (F) is produced when the said number lies outside a predetermined tolerance range of the counted number of sampling operations.

Fig. 1

Fig. 2

Fig. 3

Fig. 4

S1 — E = 1

S2 — c1 = -2

S3 — c2 = 0

T

S4 — E = 0

S5 — c1<=c1+1

S6 — $u_{old}$ <=$u_{out}$

S7 — $u_{out}$ = $u_{old}$    nein

ja

S11 — c2<=c2+1

S8 — c2<=0

S12 — c2 = $t_{Delta-max}$    nein

S9 — c1 = $c1_{max}$    nein

ja

S

ja

S10 — F = 1

I

Fig. 5

S13 — $u_{out} \gtrless u_{FS}$ — ja → F = 1 → (I) — S14

nein

S15 — $u_{max} = u_{old}$

S16 — $u_{Delta} = u_{max}/c1$

S17 — E = 1

S18 — $u_{plus} <= 0$

(W)

S19 — E = 0

(M)

S20 — $u_{plus} <= u_{plus} + u_{Delta}$

S21 — $u_{plus} \gtrless u_{out}$ — ja → F = 1 → (I) — S22

nein

S23 — $u_{plus} \gtreqless u_{max}$ — ja → F = 0 → (I) — S24

nein

S25 — $u_{out} \gneq u_{FS}$ — ja → F = 1 → I — S26

nein

S27 — $t_{Delta} <= SHR(c1,n)$

S28 — E = 1

S29 — $u_{plus} <= 0$

S30 — c2 <= 0

W

## Fig. 6

S31 — E = 0

M

S32 — $c2 = t_{Delta}$ — nein → c2 <= c2+1 — S36

ja

S33 — c2 <= 1

S34 — $u_{plus} <= u_{plus} + 1$

S35 — $u_{plus} \gneq u_{out}$ — ja → F = 1 → I — S37

nein

S38 — $u_{plus} = u_{FS}$ — ja → F = 0 → I — S39

nein

# Fig. 7